# DEMANDE DE BREVET EUROPEEN

(11) **EP 4 752 818 A1**
(43) Date de publication de la demande: **03.06.2026**
(21) Numéro de dépôt: 25217896.7
(22) Date de dépôt: 24.11.2025
(51) Int. Cl.: G06Q 50/06, H02J 13/00, G01R 11/56, H02J 13/12, H02J 13/13

(54) **PROCEDE DE RELEVE D'INFORMATIONS DE CONSOMMATION DANS UN SYSTEME DE GESTION AUTOMATISEE DE COMPTEURS INTELLIGENTS**

(30) Priorité: 28.11.2024 FR 2413160
(71) Demandeur: SAGEMCOM ENERGY & TELECOM SAS, 92270 Bois-Colombes (FR)
(72) Inventeur: TEBOULLE, Henri, 92270 BOIS-COLOMBES (FR); ROTER, Ziv, 92270 BOIS-COLOMBES (FR)
(74) Mandataire: Cabinet Le Guen Maillet

(57) **Abrégé**

Un système de gestion automatisée comporte des compteurs électriques intelligents primaires et des compteurs électriques intelligents secondaires, chaque compteur électrique intelligent primaire supervisant une installation électrique générale, chaque compteur électrique intelligent secondaire étant connecté en aval d'un dit compteur électrique intelligent primaire et supervisant une installation électrique dédiée. Le système de gestion automatisée comprenant en outre un premier système d'information gérant les compteurs électriques intelligents primaires et un deuxième système d'information gérant les compteurs électriques intelligents secondaires. Chaque compteur électrique intelligent primaire collecte (306) des informations de consommation électrique de l'installation électrique générale, et chaque compteur électrique intelligent secondaire collecte (301) des informations de consommation électrique de l'installation électrique dédiée, pour imputer la consommation électrique à un abonnement. Chaque compteur électrique intelligent secondaire collecte (302) des informations de consommation électrique intrinsèque du compteur électrique intelligent secondaire en question pour que le premier système d'information impute cette consommation électrique au deuxième système d'information.

## Description

### DOMAINE TECHNIQUE

Au moins un mode de réalisation concerne un procédé de relève d'informations de consommation électrique dans un système de gestion automatisée de compteurs électriques intelligents (« smart electricity meters » en anglais) dans lequel un compteur électrique intelligent secondaire, qui est dédié à une installation électrique spécifique, est connecté à une alimentation électrique d'une installation électrique générale qui est supervisée par un compteur électrique intelligent primaire indépendant du compteur électrique intelligent secondaire.

### ETAT DE LA TECHNIQUE ANTERIEURE

Il est connu des compteurs électriques intelligents qui comprennent des interfaces de communication à longue portée, telles que des interfaces de communication cellulaire ou des interfaces de communication par courants porteurs en ligne PLC (« PowerLine Communications » en anglais), permettant à un système de gestion automatisée d'effectuer une relève à distance de données de consommation. Des données de consommation peuvent ainsi être transmises, à intervalles réguliers ou sur demande, jusqu'à un système d'information IS (« Information System » en anglais) les traitant de manière centralisée. Parfois plusieurs tels systèmes d'information IS, appartenant typiquement à des opérateurs distincts, peuvent partager une même infrastructure de relève d'informations de consommation de ces compteurs électriques intelligents.

Il existe un besoin, au sein d'une installation électrique générale, de distinguer une consommation électrique d'une sous-partie de ladite installation électrique générale qui est dédiée à un usage spécifique, comme par exemple la recharge de véhicules électriques, du reste de la consommation électrique de ladite installation électrique générale.

Il est par ailleurs souhaitable que la consommation électrique de cette sous-partie de l'installation électrique générale puisse être gérée par un système d'information IS distinct de celui qui gère la consommation électrique du reste de ladite installation électrique générale, car les usages spécifiques peuvent nécessiter des abonnements spécifiques afin de gérer la balance de charge du réseau électrique qui alimente les installations électriques.

### EXPOSE DE L'INVENTION

A cet effet, il proposé ici un procédé de relève de consommation électrique dans un système de gestion automatisée comprenant des compteurs électriques intelligents primaires et des compteurs électriques intelligents secondaires, chaque compteur électrique intelligent primaire supervisant une installation électrique générale, chaque compteur électrique intelligent secondaire étant connecté en aval d'un dit compteur électrique intelligent primaire et supervisant une installation électrique dédiée qui est une sous-partie de l'installation électrique générale supervisée par le compteur électrique intelligent primaire en question, le système de gestion automatisée comprenant en outre un premier système d'information gérant les compteurs électriques intelligents primaires et un deuxième système d'information gérant les compteurs électriques intelligents secondaires, le procédé comportant les étapes suivantes, pour chaque dite installation électrique générale qui comporte un dit compteur électrique intelligent primaire et un dit compteur électrique intelligent secondaire et à laquelle est associé un abonnement de distribution électrique déclaré auprès du premier système d'information et du deuxième système d'information :
- le compteur électrique intelligent primaire collecte des informations de consommation électrique de l'installation électrique générale, et les transmet au premier système d'information ;
- le compteur électrique intelligent secondaire collecte des informations de consommation électrique de l'installation électrique dédiée et des informations de consommation électrique intrinsèque dudit compteur électrique intelligent secondaire, et les transmet au premier système d'information et au deuxième système d'information ;
- le premier système d'information soustrait de la consommation électrique de l'installation électrique générale la consommation électrique de l'installation électrique dédiée et la consommation électrique intrinsèque du compteur électrique intelligent secondaire, et en impute le résultat à l'abonnement ;
- le premier système d'information impute au deuxième système d'information la consommation électrique intrinsèque dudit compteur électrique intelligent secondaire ; et
- le deuxième système d'information impute à l'abonnement la consommation électrique de l'installation électrique dédiée.

Ainsi, chacun des premier et deuxième systèmes d'information est à même de gérer sa part de charge sur le réseau électrique, en prenant particulièrement en compte la consommation électrique du compteur électrique intelligent secondaire dont il doit être tenu compte par le deuxième système d'information dans l'impact envers la charge du réseau électrique mais qui n'est pas imputable directement à la consommation électrique de l'installation électrique dédiée (non imputable à l'abonné puisque c'est une consommation électrique d'infrastructure de distribution, qui d'ailleurs existe même lorsque l'alimentation électrique de l'installation dédiée est coupée).

Selon un mode de réalisation particulier, le premier système d'information transmet au deuxième système d'information les informations de consommation électrique intrinsèque dudit compteur électrique intelligent secondaire.

Ainsi, le deuxième système d'information peut vérifier la consommation électrique qui lui est imputée par le premier système d'information.

Selon un mode de réalisation particulier, le premier système d'information transmet en outre au deuxième système d'information les informations de consommation électrique de l'installation électrique dédiée.

Ainsi, le deuxième système d'information peut vérifier la consommation électrique soustraite par le premier système d'information à la consommation électrique de l'installation électrique générale.

Selon un mode de réalisation particulier, les informations de consommation électrique intrinsèque dudit compteur électrique intelligent secondaire sont obtenues par mesures réalisées grâce à un shunt installé en entrée d'alimentation électrique interne dudit compteur électrique intelligent secondaire.

Ainsi, la mesure de la consommation électrique intrinsèque dudit compteur électrique intelligent secondaire est précise et qualifiée (métrologique).

Selon un mode de réalisation particulier, les informations de consommation électrique intrinsèque dudit compteur électrique intelligent secondaire sont obtenues par mesures réalisées grâce à une résistance installée en entrée d'alimentation électrique interne dudit compteur électrique intelligent secondaire.

Ainsi, la mesure de la consommation électrique intrinsèque dudit compteur électrique intelligent secondaire est fiable.

Selon un mode de réalisation particulier, les informations de consommation électrique intrinsèque dudit compteur électrique intelligent secondaire sont obtenues par mesures réalisées par lecture d'un registre, ou d'un espace mémoire, fournissant une estimation prédéterminée de la consommation électrique intrinsèque dudit compteur électrique intelligent secondaire.

Ainsi, la consommation électrique intrinsèque dudit compteur électrique intelligent secondaire est aisément déterminée.

Selon un mode de réalisation particulier, ledit compteur électrique intelligent secondaire comporte un organe de coupure pour suspendre et rétablir l'alimentation électrique de l'installation électrique dédiée.

Ainsi, les compteurs électriques intelligents secondaires sont adaptés à des installations électriques dédiées de différentes natures (alimentation électrique de pompes à chaleur, recharge de véhicules électriques, etc.).

Selon un mode de réalisation particulier, l'installation électrique dédiée comporte un chargeur pour véhicule électrique qui est muni d'un organe de coupure commandable à distance par ledit compteur électrique intelligent secondaire pour suspendre et rétablir l'alimentation électrique de l'installation électrique dédiée.

Ainsi, les compteurs électriques intelligents secondaires sont adaptés à des installations électriques dédiées à la recharge de véhicules électriques.

Il est également proposé ici un système de gestion automatisée comprenant des compteurs électriques intelligents primaires et des compteurs électriques intelligents secondaires, chaque compteur électrique intelligent primaire étant configuré pour superviser une installation électrique générale, chaque compteur électrique intelligent secondaire étant connecté en aval d'un dit compteur électrique intelligent primaire et étant configuré pour superviser une installation électrique dédiée qui est une sous-partie de l'installation électrique générale supervisée par le compteur électrique intelligent primaire en question, le système de gestion automatisée comprenant en outre un premier système d'information gérant les compteurs électriques intelligents primaires et un deuxième système d'information gérant les compteurs électriques intelligents secondaires,
le système de gestion automatisée comprenant de la circuiterie électronique configurée pour implémenter les étapes suivantes, pour chaque dite installation électrique générale qui comporte un dit compteur électrique intelligent primaire et un dit compteur électrique intelligent secondaire et à laquelle est associé un abonnement de distribution électrique déclaré auprès du premier système d'information et du deuxième système d'information :
- le compteur électrique intelligent primaire collecte des informations de consommation électrique de l'installation électrique générale, et les transmet au premier système d'information ;
- le compteur électrique intelligent secondaire collecte des informations de consommation électrique de l'installation électrique dédiée et des informations de consommation électrique intrinsèque dudit compteur électrique intelligent secondaire, et les transmet au premier système d'information et au deuxième système d'information ;
- le premier système d'information soustrait de la consommation électrique de l'installation électrique générale la consommation électrique de l'installation électrique dédiée et la consommation électrique intrinsèque du compteur électrique intelligent secondaire, et en impute le résultat à l'abonnement ;
- le premier système d'information impute au deuxième système d'information la consommation électrique intrinsèque dudit compteur électrique intelligent secondaire ; et
- le deuxième système d'information impute à l'abonnement la consommation électrique de l'installation électrique dédiée.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un système de gestion automatisée de compteurs électriques intelligents dans lequel la présente invention peut être implémentée, dans un premier mode de réalisation ;
[Fig. 2] illustre schématiquement le système de gestion automatisée de compteurs électriques intelligents, dans un deuxième mode de réalisation ;
[Fig. 3] illustre schématiquement des opérations et échanges intervenant dans le système de gestion automatisée de compteurs électriques intelligents, dans le premier mode de réalisation ;
[Fig. 4] illustre schématiquement des opérations et échanges intervenant dans le système de gestion automatisée de compteurs électriques intelligents, dans le deuxième mode de réalisation ; et
[Fig. 5] illustre schématiquement un exemple de plateforme matérielle utilisable dans le système de gestion automatisée de compteurs électriques intelligents.

### EXPOSE DETAILLE DE MODES DE REALISATION

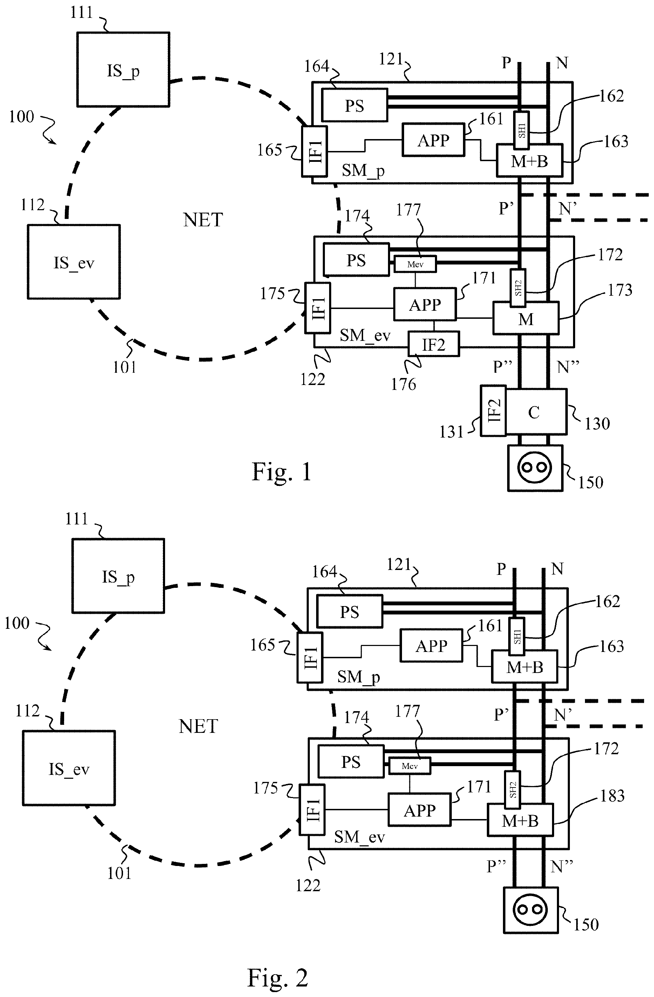

La Fig. 1 illustre schématiquement un système de gestion automatisée 100 dans lequel la présente invention peut être implémentée. Le système de gestion automatisée 100 est configuré pour réaliser une collecte de données de consommation électriques issues de mesures effectuées par des compteurs électriques intelligents.

Le système de gestion automatisée 100 comprend des compteurs électriques intelligents SM_p 121 d'un premier type, dits compteurs électriques intelligents primaires. Chaque compteur électrique intelligent primaire SM_p 121 supervise la distribution électrique pour une installation électrique sur laquelle est potentiellement connecté, en aval du compteur électrique intelligent primaire SM_p 121 par rapport au réseau électrique, un ou plusieurs compteurs électriques intelligents 122 d'un deuxième type, dits compteurs électriques intelligents secondaires. Ces compteurs électriques intelligents secondaires 122 supervisent donc la distribution électrique pour une installation électrique dédiée, qui est une sous-partie d'une installation électrique générale supervisée par le compteur électrique intelligent primaire SM_p 121.

Les compteurs électriques intelligents secondaires 122 sont ainsi dédiés à la supervision de distribution électrique pour un usage spécifique, comme par exemple une alimentation de pompe à chaleur ou la recharge d'un véhicule électrique. Ces compteurs électriques intelligents secondaires 122 sont parfois appelés « dispositifs compteurs dédiés » DMD (« Dedicated Metering Devices » en anglais). Il est considéré à titre préférentiel par la suite que les compteurs électriques intelligents secondaires 122 sont dédiés à la supervision de distribution électrique pour la recharge de véhicules électriques.

Les compteurs électriques intelligents secondaires 122 et les compteurs électriques intelligents primaires SM_p 121 sont gérés à distance par des systèmes d'information IS (« Information System » en anglais) respectifs distincts. Sur le schéma de la Fig. 1, les compteurs électriques intelligents primaires SM_p 121 sont gérés à distance par un système d'information IS_p 111 et les compteurs électriques intelligents secondaires SM_ev 122 sont gérés à distance par un système d'information IS_ev 112.

Chaque installation électrique est associée à un abonnement qui définit des conditions de distribution électrique à ladite installation électrique, par exemple des limites de puissance autorisée ou des conditions spécifiques de distribution électrique dans certaines plages horaires. Lorsque l'installation électrique est équipée d'un dit compteur électrique intelligent primaire SM_p 121 et d'un dit compteur électrique intelligent secondaire SM_ev 122, une première partie de l'abonnement (ou un premier abonnement) est gérée par le système d'information IS_p 111 et une deuxième partie de l'abonnement (ou un deuxième abonnement) est gérée par le système d'information IS_ev 112.

Dans une même installation électrique chez un abonné, le compteur électrique intelligent secondaire SM_ev 122 et le compteur électrique intelligent primaire SM_p 121 sont des dispositifs séparés qui ne communiquent pas entre eux, et sont donc, en ce sens, indépendants l'un de l'autre. Un tel agencement facilite la mise en place chez les abonnés. Ainsi, pour une installation électrique considérée, le compteur électrique intelligent primaire SM_p 121 est installé préalablement, typiquement par un agent d'un premier fournisseur d'électricité, directement sur l'arrivée électrique Phase P / Neutre N côté réseau électrique, et le compteur électrique intelligent secondaire SM_ev 122 dédié à la recharge d'un véhicule électrique est installé ultérieurement, potentiellement par un agent d'un deuxième fournisseur d'électricité, sur une alimentation électrique Phase P' / Neutre N' en sortie du compteur électrique intelligent primaire SM_p 121. Le compteur électrique intelligent secondaire SM_ev 122 est typiquement installé à distance du compteur électrique intelligent primaire SM_p 121 *(i.e.,* pas à proximité immédiate). En sortie du compteur électrique intelligent secondaire SM_ev 122, une alimentation électrique Phase P" / Neutre N" permet d'alimenter électriquement ladite installation électrique dédiée. Dans le cas de la Fig. 1, l'installation électrique dédiée comporte un connecteur électrique 150 relié à l'alimentation électrique Phase P" / Neutre N" en sortie du compteur électrique intelligent secondaire SM_ev 122 par l'intermédiaire d'un chargeur C 130 adapté à la recharge de véhicule électrique. Le chargeur C 130 comporte alors un organe de coupure (« breaker » en anglais) commandable permettant de sélectivement autoriser ou inhiber l'alimentation électrique du connecteur électrique 150.

Il convient de noter que le compteur électrique intelligent primaire SM_p 121 peut être un compteur polyphasé et le compteur électrique intelligent secondaire SM_ev 122 un compteur monophasé alors alimenté par une seule des phases d'alimentation électrique fournies par le compteur électrique intelligent primaire SM_p 121.

Dans le schéma de la Fig. 1, chaque compteur électrique intelligent secondaire SM_ev 122 comporte une interface de communication IF2 176 adaptée et configurée pour communiquer avec le chargeur C 130. Réciproquement, le chargeur C 130 comporte une interface de communication IF2 131 adaptée et configurée pour communiquer avec le compteur électrique intelligent secondaire SM_ev 122 en question. Étant donné que le compteur électrique intelligent secondaire SM_ev 122 et le chargeur C 130 sont typiquement installés à proximité l'un de l'autre, les interfaces de communication IF2 131, 176 sont adaptées et configurées pour établir un lien de communication à courte portée, par exemple conformément aux spécifications de télérelève M-Bus (« Meter Bus » en anglais), telles que définies dans la norme EN 13757-2, ou aux spécifications wM-Bus (« Wireless M-Bus » en anglais), telles que définies dans la norme EN 13757-4. D'autres technologies de communication à courte portée peuvent être utilisées, telles que Bluetooth, Wi-Fi, Zigbee, KNX, KNX-RF, RS485... Cela permet notamment au compteur électrique intelligent secondaire SM_ev 122 de commander à distance des actions sur l'organe de coupure (breaker) du chargeur C 130. Un appairage entre le compteur électrique intelligent secondaire SM_ev 122 et le chargeur C 130 est préférentiellement réalisé au moment de la mise en service du compteur électrique intelligent secondaire SM_ev 122 et du chargeur C 130.

Le système d'information IS_p 111 est un équipement gestionnaire centralisé et les compteurs électriques intelligents primaires SM_p 121 sont inscrits auprès du système d'information IS_p 111, selon des abonnements souscrits par des utilisateurs (abonnés) respectifs auprès d'un distributeur (opérateur fournisseur d'électricité) pour lequel le système d'information IS_p 111 opère.

La gestion à distance des compteurs électriques intelligents primaires SM_p 121 par le système d'information IS_p 111, et notamment la relève d'informations de consommation électrique, s'effectue au travers d'un réseau de communication NET 101. Pour ce faire, chaque compteur électrique intelligent primaire SM_p 121 dispose d'une interface de communication IF1 165 adaptée et configurée pour communiquer via le réseau de communication NET 101.

Le système d'information IS_ev 112 est un équipement gestionnaire centralisé et les compteurs électriques intelligents secondaires SM_ev 122 sont inscrits auprès du système d'information IS_ev 112, selon des abonnements souscrits par les utilisateurs (abonnés) respectifs auprès d'un distributeur (opérateur fournisseur d'électricité) pour lequel le système d'information IS_ev 112 opère.

La gestion à distance des compteurs électriques intelligents secondaires SM_ev 122 par le système d'information IS_ev 112, et notamment la relève d'informations de consommation électrique, s'effectue aussi au travers du réseau de communication NET 101. Pour ce faire, chaque compteur électrique intelligent secondaire SM_ev 122 dispose d'une interface de communication IF1 175 adaptée et configurée pour communiquer via le réseau de communication NET 101.

Par exemple, le réseau de communication NET 101 est un réseau de communication sans-fil de type 5G (5^{e} Génération). Selon d'autres exemples, le réseau de communication NET 101 est un réseau de communication sans-fil de type GPRS (« General Packet Radio Service » en anglais), UMTS (« Universal Mobile Telecommunication System » en anglais), LTE-MTC (« Long-Term Evolution Machine Type Communication » en anglais) aussi connu sous le diminutif LTE-M, ou NB-IoT (« NarrowBand Internet of Things » en anglais). Selon encore un autre exemple, le réseau de communication NET 101 est un réseau de communication par courants porteurs en ligne PLC (« PowerLine Communications » en anglais), par exemple conforme au standard PRIME ou G3-PLC.

Par exemple, chaque système d'information IS_p 111, IS_ev 112 comprend diverses composantes dont un système de tête de réseau HES (« Head-End System » en anglais), un système de gestion de données de compteurs MDMS (« Meter Data Management System » en anglais), et un système de gestion de clefs KMS (« Key Management System » en anglais). Le système de tête de réseau HES est configuré pour effectuer la gestion de transmissions dans le cadre de la gestion à distance des compteurs électriques intelligents, et notamment dans le cadre de la collecte de données de consommation. Le système de gestion de données de compteurs MDMS est configuré pour traiter les données de consommation collectées. Le système de gestion de clefs KMS est configuré pour stocker des clefs de chiffrement qui seraient nécessaires au système de gestion de données de compteurs MDMS et aux compteurs électriques intelligents, ainsi qu'à tout équipement intermédiaire entre le système d'information IS_p 111, IS_ev 112 et les compteurs électriques intelligents en question, comme par exemple une passerelle ou un concentrateur de données. Les composantes de système d'information IS_p 111, IS_ev 112 communiquent entre elles par exemple en utilisant l'Internet, ou plus généralement un réseau de type IP (« Internet Protocol » en anglais), ou en utilisant potentiellement un réseau privé virtuel VPN (« Virtual Private Network » en anglais).

Chaque compteur électrique intelligent primaire SM_p 121 comporte un dispositif d'alimentation interne PS 164 utilisé pour alimenter électriquement, à partir de la Phase P et du Neutre N, des éléments internes du compteur électrique intelligent primaire SM_p 121. Outre l'interface de communication IF1 165, ces éléments internes du compteur électrique intelligent primaire SM_p 121 incluent une fonction applicative APP 161, par exemple exécutée par un processeur muni d'une mémoire ou implémentée par un composant électronique dédié, configurée pour contrôler le compteur électrique intelligent primaire SM_p 121, notamment dans le cadre de la relève d'informations de consommation électrique. Les éléments internes du compteur électrique intelligent primaire SM_p 121 incluent en outre une fonction de métrologie équipée d'un organe de coupure (breaker) 163 (notée M+B sur la Fig. 1) qui effectue des mesures de consommation électrique de l'installation électrique générale supervisée par le compteur électrique intelligent primaire SM_p 121 en question. L'organe de coupure (breaker) du compteur électrique intelligent primaire SM_p 121 permet au système d'information IS_p 111 de sélectivement autoriser ou inhiber l'alimentation électrique de l'installation électrique générale supervisée par le compteur électrique intelligent primaire SM_p 121.

La consommation électrique de l'installation électrique générale est mesurée grâce à un shunt SH1 162 installé en entrée du compteur électrique intelligent primaire SM_p 121 (Phase P, après la prise d'alimentation du dispositif d'alimentation interne PS 164 dudit compteur électrique intelligent primaire SM_p 121), et des mesures de tension à ses bornes permettent d'obtenir une indication précise et qualifiée de la consommation électrique de l'installation électrique générale. Aucune mesure de consommation électrique intrinsèque du compteur électrique intelligent primaire SM_p 121 n'est nécessaire puisque la mesure de consommation grâce au shunt SH1 162 ne prend pas en compte la consommation électrique des éléments internes du compteur électrique intelligent primaire SM_p 121.

Chaque compteur électrique intelligent secondaire SM_ev 122 comporte un dispositif d'alimentation interne PS 174 utilisé pour alimenter électriquement, à partir de la Phase P' et du Neutre N', des éléments internes du compteur électrique intelligent secondaire SM_ev 122. Outre l'interface de communication IF1 175 et l'interface de communication IF2 176, ces éléments internes du compteur électrique intelligent secondaire SM_ev 122 incluent une fonction applicative APP 171, par exemple exécutée par un processeur muni d'une mémoire ou implémentée par un composant électronique dédié, configurée pour contrôler le compteur électrique intelligent secondaire SM_ev 122, notamment dans le cadre de la relève d'informations de consommation électrique. Les éléments internes du compteur électrique intelligent secondaire SM_ev 122 incluent en outre une fonction de métrologie 173 (notée M sur la Fig. 1) qui effectue des mesures de consommation électrique de l'installation électrique dédiée qui est supervisée par le compteur électrique intelligent secondaire SM_ev 122 en question. Aucun organe de coupure (breaker) n'est ici utile au compteur électrique intelligent secondaire SM_ev 122, puisque le chargeur C 130 est lui-même muni d'un tel organe de coupure (breaker).

La consommation électrique de l'installation électrique dédiée est mesurée grâce à un shunt SH2 172 installé en entrée du compteur électrique intelligent secondaire SM_ev 122 (Phase P', après la prise d'alimentation du dispositif d'alimentation interne PS 174 dudit compteur électrique intelligent secondaire SM_ev 122), et des mesures de tension à ses bornes permettent d'obtenir une indication précise et qualifiée de la consommation électrique de l'installation électrique dédiée.

Chaque compteur électrique intelligent secondaire SM_ev 122 comporte en outre un dispositif Mev 177 de fourniture de données de consommation électrique intrinsèque du compteur électrique intelligent secondaire SM_ev 122. Dans un mode de réalisation particulier, le dispositif Mev 177 est un shunt installé en entrée de l'alimentation électrique interne PS 174 du compteur électrique intelligent secondaire SM_ev 122, et des mesures de tension à ses bornes permettent d'obtenir une indication précise et qualifiée de la consommation électrique intrinsèque du compteur électrique intelligent secondaire SM_ev 122. Dans un autre mode de réalisation particulier, le dispositif Mev 177 est une résistance installée en entrée de l'alimentation électrique interne PS 174 du compteur électrique intelligent secondaire SM_ev 122 et des mesures de tension à ses bornes permettent d'obtenir une indication fiable de la consommation électrique intrinsèque du compteur électrique intelligent secondaire SM_ev 122. Dans encore un autre mode de réalisation particulier, le dispositif Mev 177 est un registre, ou un espace mémoire, fournissant une estimation prédéterminée (par exemple, mesurée en laboratoire) de la consommation électrique intrinsèque du compteur électrique intelligent secondaire SM_ev 122.

La **Fig. 2** illustre schématiquement un système de gestion automatisée 100 dans un autre mode de réalisation.

Dans le cas de la Fig. 2, le chargeur C 130 est absent et le connecteur électrique 150 est directement relié à l'alimentation électrique Phase P" / Neutre N" en sortie du compteur électrique intelligent secondaire SM_ev 122. Le compteur électrique intelligent secondaire SM_ev 122 n'a alors pas besoin de l'interface de communication IF2 176. Le compteur électrique intelligent secondaire SM_ev 122 est alors équipé d'un organe de coupure (breaker). En d'autres termes, la fonction de métrologie 173 de la Fig. 1 est remplacée par une fonction de métrologie équipée d'un organe de coupure (breaker) 183 (notée M+B sur la Fig. 2).

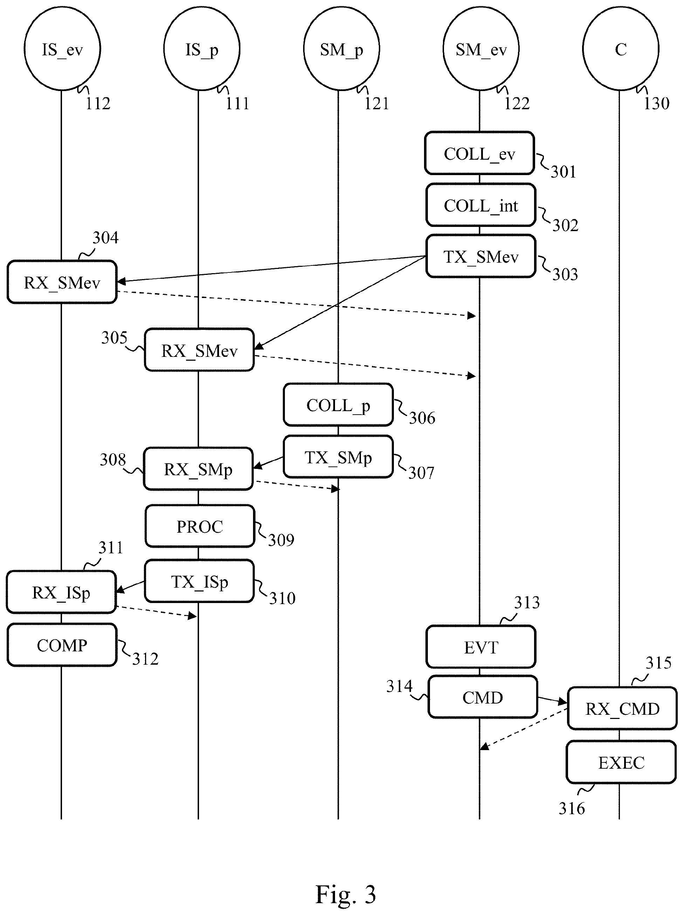

La **Fig. 3** illustre schématiquement des opérations et échanges intervenant dans le système de gestion automatisée 100, dans le mode de réalisation de la Fig. 1. Les opérations et échanges de la Fig. 3 permettent notamment la relève d'informations de consommation électrique, et sont par exemple réalisés quotidiennement.

Dans une étape 301 (notée COLL_ev sur la Fig. 3), le compteur électrique intelligent secondaire SM_ev 122 collecte des informations de consommation électrique de l'installation électrique dédiée (index de consommation, courbe de charge de consommation). Le compteur électrique intelligent secondaire SM_ev 122 peut en outre collecter des informations de production électrique de l'installation électrique dédiée (index de production, courbe de charge de production), par exemple lorsqu'un véhicule électrique fournit via l'installation électrique dédiée de l'énergie stockée sur batterie.

Dans une étape 302 (notée COLL_int sur la Fig. 3), le compteur électrique intelligent secondaire SM_ev 122 collecte des informations de consommation électrique intrinsèque du compteur électrique intelligent secondaire SM_ev 122 (index de consommation, courbe de charge de consommation).

Dans une étape 303 (notée TX_SMev sur la Fig. 3), le compteur électrique intelligent secondaire SM_ev 122 transmet les informations de consommation électrique collectées aux étapes 301 et 302. Ces informations de consommation électrique sont, d'une part, transmises au système d'information IS_ev 112 qui les reçoit dans une étape 304 (notée RX_SMev sur la Fig. 3). Ces informations de consommation électrique sont, d'autre part, transmises au système d'information IS_p 111 qui les reçoit dans une étape 305 (notée aussi RX_SMev sur la Fig. 3). Comme schématiquement illustré par les flèches en pointillés sur la Fig. 3 au départ des étapes 304 et 305, le système d'information IS_ev 112 et le système d'information IS_p 111 peuvent envoyer un acquittement en réponse aux informations de consommation électrique reçues du compteur électrique intelligent secondaire SM_ev 122.

À réception, le système d'information IS_p 111 impute au système d'information IS_ev 112 la consommation électrique intrinsèque du compteur électrique intelligent secondaire SM_ev 122.

De plus, à réception, le système d'information IS_ev 112 impute à l'abonnement concerné la consommation électrique de l'installation électrique dédiée dans sa gestion de la charge du réseau électrique. Le système d'information IS_ev 112 sait en outre quelle consommation électrique va lui être imputée par le système d'information IS_p 111 dans la gestion de la charge du réseau électrique, c'est-à-dire la consommation électrique intrinsèque du compteur électrique intelligent secondaire SM_ev 122.

Dans une étape 306 (notée COLL_p sur la Fig. 3), le compteur électrique intelligent primaire SM_p 121 collecte des informations de consommation électrique de l'installation électrique générale.

Dans une étape 307 (notée TX_SMp sur la Fig. 3), le compteur électrique intelligent primaire SM_p 121 transmet au système d'information IS_p 111 les informations de consommation électrique collectées à l'étape 306. Le système d'information IS_p 111 reçoit ces informations de consommation électrique de l'installation électrique générale dans une étape 308 (notée RX_SMp sur la Fig. 3). Comme schématiquement illustré par une flèche en pointillés sur la Fig. 3 au départ de l'étape 308, le système d'information IS_p 111 peut envoyer un acquittement en réponse aux informations de consommation électrique reçues du compteur électrique intelligent primaire SM_p 121.

Dans une étape 309 (notée PROC sur la Fig. 3), le système d'information IS_p 111 effectue un traitement sur les informations de consommation reçues aux étapes 305 et 308. Plus particulièrement, le système d'information IS_p 111 soustrait de la consommation électrique indiquée dans les informations reçues à l'étape 308 la consommation électrique indiquée dans les informations reçues à l'étape 305, y compris la consommation intrinsèque du compteur électrique intelligent secondaire SM_ev 122. Le système d'information IS_p 111 détermine ainsi la consommation électrique de l'installation électrique générale en dehors de l'installation électrique dédiée, et l'impute à l'abonnement concerné dans sa gestion de la charge du réseau électrique.

Il convient de noter que le système d'information IS_p 111 pourrait recevoir les informations de consommation électrique en provenance du compteur électrique intelligent primaire SM_p 121 avant de recevoir celles en provenance du compteur électrique intelligent secondaire SM_ev 122.

Dans une étape 310 (notée TX_ISp sur la Fig. 3), le système d'information IS_p 111 transmet au système d'information IS_ev 112 les informations de consommation électrique intrinsèque du compteur électrique intelligent secondaire SM_ev 122 reçues à l'étape 305. En variante, le système d'information IS_p 111 transmet au système d'information IS_ev 112 l'ensemble des informations de consommation électrique reçues à l'étape 305. Le système d'information IS_ev 112 reçoit ces informations de consommation électrique dans une étape 311 (notée RX_ISp sur la Fig. 3). Comme schématiquement illustré par une flèche en pointillés sur la Fig. 3 au départ de l'étape 311, le système d'information IS_ev 112 peut envoyer un acquittement en réponse aux informations de consommation électrique reçues du système d'information IS_p 111.

Ainsi, dans une étape 312 (notée COMP sur la Fig. 3), le système d'information IS_ev 112 compare les informations de consommation électrique reçues à l'étape 304 de la part du compteur électrique intelligent secondaire SM_ev 122 et les informations de consommation électrique reçues à l'étape 311 de la part du système d'information IS_p 111. Le système d'information IS_ev 112 peut ainsi vérifier la part de consommation électrique qui lui est imputée par le système d'information IS_p 111. Si d'aventure les informations de consommation électrique reçues aux étapes 304 et 311 devaient ne pas être cohérentes entre elles, le système d'information IS_ev 112 mettrait en place une procédure de vérification approfondie, par exemple en déclenchant une demande d'intervention chez l'abonné en question afin de vérifier sur site les informations de consommation électrique et/ou le fonctionnement correct du compteur électrique intelligent secondaire SM_ev 122.

Ainsi, grâce aux opérations et échanges décrits ci-dessus, chacun des systèmes d'information IS_p 111 et IS_ev 112 est à même de gérer sa part de charge sur le réseau électrique. Ces opérations et échanges prennent particulièrement en compte la consommation électrique du compteur électrique intelligent secondaire SM_ev 122 dont il doit être tenu compte par le système d'information IS_ev 112 dans l'impact envers la charge du réseau électrique mais qui n'est pas imputable directement à la consommation électrique de l'installation électrique dédiée (non imputable à l'abonné puisque c'est une consommation électrique d'infrastructure de distribution électrique à la charge des fournisseurs d'énergie, qui d'ailleurs existe même lorsque l'alimentation électrique de l'installation dédiée est coupée).

Dans le cadre de la gestion de la charge du réseau électrique, l'alimentation électrique de l'installation électrique dédiée peut être amenée à être coupée pendant une période temporelle, dite période de suspension, à l'issue de laquelle l'alimentation électrique de l'installation électrique dédiée est rétablie. L'organe de coupure du chargeur C 130 est utilisé à cet effet sous contrôle du compteur électrique intelligent secondaire SM_ev 122, éventuellement sur ordre du système d'information IS_ev 112. Ainsi, dans une étape 313 (notée EVT sur la Fig. 3), le compteur électrique intelligent secondaire SM_ev 122 détecte la survenue d'un événement (e.g., début ou fin de période de suspension) requérant l'actionnement de l'organe de coupure du chargeur C 130. Le début de la période de suspension fait par exemple suite à un dépassement de puissance délivrée à l'installation électrique dédiée comparativement à la puissance autorisée par le système d'information IS_ev 112 au regard d'une balance de charge sur le réseau électrique. Selon un autre exemple, le début de la période de suspension fait suite à la détection d'entrée dans une plage horaire pendant laquelle l'installation électrique dédiée n'est pas autorisée par le système d'information IS_ev 112 à charger le réseau électrique au regard de la balance de charge sur le réseau électrique.

Alors, dans une étape 314 (notée CMD sur la Fig. 3), le compteur électrique intelligent secondaire SM_ev 122 transmet au chargeur C 130 une commande instruisant le chargeur C 130 d'actionner son organe de coupure (ouverture ou fermeture selon si c'est le début ou la fin respectivement de la période de suspension). Le chargeur C 130 reçoit la commande dans une étape 315 (notée RX_CMD sur la Fig. 3). Comme schématiquement illustré par une flèche en pointillés sur la Fig. 3 au départ de l'étape 315, le chargeur C 130 peut envoyer un acquittement en réponse à la commande. Et dans une étape 316 (notée EXEC sur la Fig. 3), le chargeur C 130 exécute la commande selon les instructions du compteur électrique intelligent secondaire SM_ev 122. À noter que pendant la période de suspension, le compteur électrique intelligent secondaire SM_ev 122 continue de fonctionner (tant que le compteur électrique intelligent primaire SM_p 121 continue de l'alimenter électriquement) et la consommation électrique intrinsèque du compteur électrique intelligent secondaire SM_ev 122 persiste. Il doit en être tenu compte dans la balance de charge du réseau électrique.

Dans un mode de réalisation particulier, les échanges décrits ci-dessus en relation avec la Fig. 3 sont conformes aux spécifications DLMS (« Device Language Message Specification » en anglais), et éventuellement aux spécifications COSEM (« Companion Specification for Energy Metering » en anglais). En variante, les échanges décrits ci-dessus sont conformes au standard ANSI C12.22 / IEEE Std 1703.

Dans un mode de réalisation particulier, les relèves d'informations de consommation électrique sont réalisées avec un chiffrement asymétrique desdites informations de consommation électrique afin d'en assurer la non-répudiation. Le chiffrement asymétrique comprend une clé de signature privée, par exemple générée à partir du numéro de série du compteur électrique intelligent en question. Une clé de signature publique est associée à la clé de signature privée, la clé de signature publique étant connue du système d'information IS auquel les informations de consommation électrique sont destinées, plus particulièrement du système de gestion de clefs KMS du système d'information IS en question. Pour construire un message sous forme chiffrée, un compteur électrique intelligent applique une fonction de hachage sur un premier doublet formé du numéro de série du compteur intelligent en question et des informations de consommation électrique à transmettre, et chiffre le résultat à l'aide de sa clef de signature privée. Un deuxième doublet est ensuite formé en juxtaposant les informations de consommation électrique à transmettre et le résultat chiffré à l'aide de la clef de signature privée, et ce deuxième doublet est transmis au système d'information IS auquel les informations de consommation électrique sont destinées, plus particulièrement au système de gestion de données de compteurs MDMS du système d'information IS en question. À réception, le système d'information IS récupère les informations de consommation électrique reçues et applique la fonction de hachage sur un doublet formé du numéro de série du compteur intelligent en question et des informations de consommation électrique. Le système d'information IS applique aussi la clef de signature publique correspondant au compteur électrique intelligent en question sur la partie chiffrée du message reçu afin de la déchiffrer. En vérifiant que le résultat de la fonction de hachage et le résultat du déchiffrement correspondent, le système d'information IS peut assurer que les informations proviennent du compteur électrique intelligent attendu et que ces informations n'ont pas été altérées en chemin.

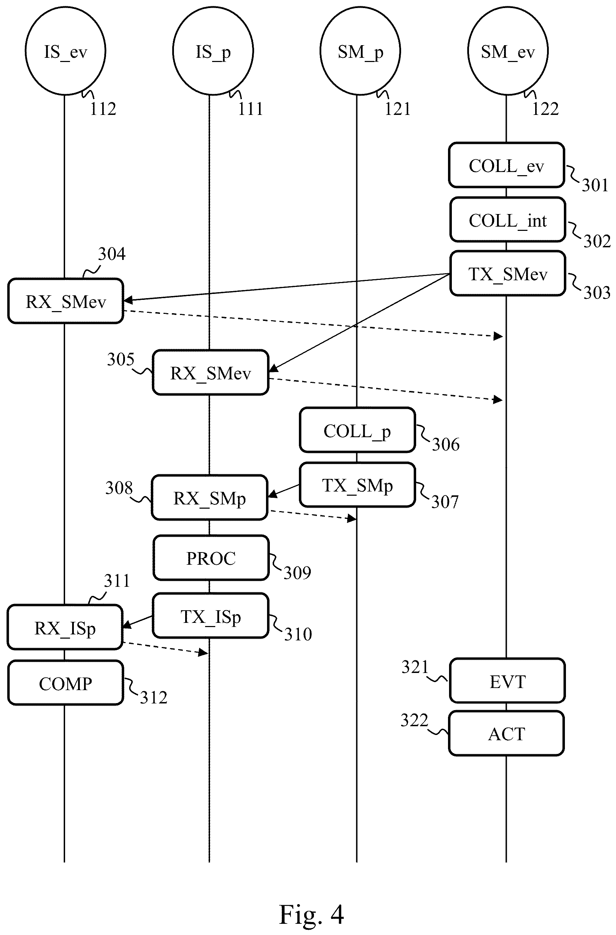

La **Fig. 4** illustre schématiquement des opérations et échanges intervenant dans le système de gestion automatisée 100, dans le mode de réalisation de la Fig. 2.

À la différence du mode de réalisation de la Fig. 1, le mode de réalisation de la Fig. 2 ne comporte pas le chargeur C 130 et un organe de coupure est inclus dans le compteur électrique intelligent secondaire SM_ev 122.

Ainsi, la Fig. 4 reprend les opérations et échanges des étapes 301 à 312 détaillées ci-dessus en relation avec la Fig. 3.

Comme dans le cadre des opérations et échange de la Fig. 3, l'alimentation électrique de l'installation électrique dédiée peut être amenée à être coupée pendant une période temporelle, dite période de suspension, à l'issue de laquelle l'alimentation électrique de l'installation électrique dédiée est rétablie. L'organe de coupure du compteur électrique intelligent secondaire SM_ev 122 est utilisé à cet effet, éventuellement sur ordre du système d'information IS_ev 112. Ainsi, dans une étape 321 (notée EVT sur la Fig. 4), le compteur électrique intelligent secondaire SM_ev 122 détecte la survenue de l'événement requérant l'actionnement de son organe de coupure. Et dans une étape 322 (notée ACT sur la Fig. 4), le compteur électrique intelligent secondaire SM_ev 122 exécute une commande d'actionnement de son organe de coupure interne (ouverture ou fermeture selon si c'est le début ou la fin respectivement de la période de suspension). À noter ici aussi que pendant la période de suspension, le compteur électrique intelligent secondaire SM_ev 122 continue de fonctionner (tant que le compteur électrique intelligent primaire SM_p 121 continue de l'alimenter électriquement) et la consommation électrique intrinsèque du compteur électrique intelligent secondaire SM_ev 122 persiste.

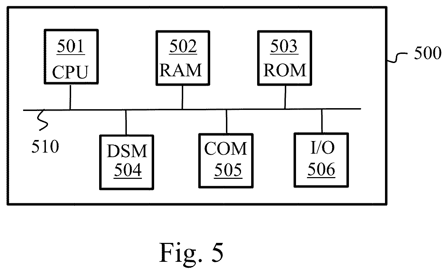

La **Fig. 5** illustre schématiquement un exemple de plateforme matérielle 500 utilisable dans le système de gestion automatisée 100. L'exemple d'architecture matérielle est ainsi adapté pour implémenter un contrôleur de système d'information IS, ou de toute composante du système d'information IS. L'exemple d'architecture matérielle est aussi adapté pour implémenter un contrôleur de compteur électrique intelligent, typiquement pour implémenter les fonctions applicatives APP 161, 171. L'exemple d'architecture matérielle est aussi adapté pour implémenter un contrôleur du chargeur C 130.

La plateforme matérielle 500 comprend alors, reliés par un bus de communication 510 : un processeur ou CPU (« Central Processing Unit » en anglais) 501 ; une mémoire vive RAM (« Random Access Memory » en anglais) 502 ; une mémoire morte ROM (« Read Only Memory » en anglais) 503, ou EEPROM (« Electrically Erasable Programmable ROM » en anglais), ou une mémoire de type Flash ; un support de stockage de données DSM (« Data Storage Medium » en anglais) 504, tel qu'un disque dur HDD (« Hard Disk Drive » en anglais), ou un lecteur de support de stockage, tel qu'un lecteur de cartes SD (« Secure Digital » en anglais) ; et au moins une interface de communication COM 505. Selon le dispositif ou équipement considéré, la plateforme matérielle 500 peut en outre comprendre des entrées/sorties (« Inputs / Outputs » en anglais) I/O 506, par exemple pour effectuer des mesures de consommation électrique.

Le processeur 501 est capable d'exécuter des instructions chargées dans la RAM 502 à partir de la ROM 503, d'une mémoire externe (non représentée), d'un support de stockage, tel qu'une carte SD, ou d'un réseau de communication. Lorsque la plateforme matérielle 500 est mise sous tension, le processeur 501 est capable de lire de la RAM 502 des instructions et de les exécuter. Ces instructions forment un programme d'ordinateur causant une implémentation, par le processeur 501, des étapes, opérations et échanges décrits ici en relation avec le dispositif ou équipement concerné.

Tout ou partie des étapes, opérations et échanges décrits ici peut ainsi être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant (« chip » en anglais) ou un ensemble de composants (« chipset » en anglais), tel qu'un FPGA (« Field-Programmable Gate Array » en anglais) ou un ASIC (« Application-Specific Integrated Circuit » en anglais). D'une manière générale, chaque dispositif ou équipement du système de gestion automatisée 100 comprend de la circuiterie électronique agencée et configurée pour implémenter les étapes, opérations et échanges décrits ici en relation avec le dispositif ou équipement en question.

## Revendications

1. Procédé de relève de consommation électrique dans un système de gestion automatisée (100) comprenant des compteurs électriques intelligents primaires (121) et des compteurs électriques intelligents secondaires (122), chaque compteur électrique intelligent primaire (121) supervisant une installation électrique générale, chaque compteur électrique intelligent secondaire (122) étant connecté en aval d'un dit compteur électrique intelligent primaire et supervisant une installation électrique dédiée qui est une sous-partie de l'installation électrique générale supervisée par le compteur électrique intelligent primaire (121) en question, le système de gestion automatisée (100) comprenant en outre un premier système d'information (111) gérant les compteurs électriques intelligents primaires (121) et un deuxième système d'information (112) gérant les compteurs électriques intelligents secondaires (122),
le procédé comportant les étapes suivantes, pour chaque dite installation électrique générale qui comporte un dit compteur électrique intelligent primaire (121) et un dit compteur électrique intelligent secondaire (122) et à laquelle est associé un abonnement de distribution électrique déclaré auprès du premier système d'information (111) et du deuxième système d'information (112) :
- le compteur électrique intelligent primaire (121) collecte (306) des informations de consommation électrique de l'installation électrique générale, et les transmet (307) au premier système d'information (111) ;
- le compteur électrique intelligent secondaire (122) collecte (301, 302) des informations de consommation électrique de l'installation électrique dédiée et des informations de consommation électrique intrinsèque dudit compteur électrique intelligent secondaire (122), et les transmet (303) au premier système d'information (111) et au deuxième système d'information (112) ;
- le premier système d'information (111) soustrait de la consommation électrique de l'installation électrique générale la consommation électrique de l'installation électrique dédiée et la consommation électrique intrinsèque du compteur électrique intelligent secondaire (122), et en impute le résultat à l'abonnement ;
- le premier système d'information (111) impute au deuxième système d'information (112) la consommation électrique intrinsèque dudit compteur électrique intelligent secondaire (122) ; et
- le deuxième système d'information (112) impute à l'abonnement la consommation électrique de l'installation électrique dédiée.

2. Procédé selon la revendication 1, dans lequel le premier système d'information (111) transmet au deuxième système d'information les informations de consommation électrique intrinsèque dudit compteur électrique intelligent secondaire (122).

3. Procédé selon la revendication 2, dans lequel le premier système d'information (111) transmet en outre au deuxième système d'information (112) les informations de consommation électrique de l'installation électrique dédiée.

4. Procédé selon l'une quelconque des revendications 1 à 3, dans lequel les informations de consommation électrique intrinsèque dudit compteur électrique intelligent secondaire (122) sont obtenues par mesures réalisées grâce à un shunt installé en entrée d'alimentation électrique interne (174) dudit compteur électrique intelligent secondaire (122).

5. Procédé selon l'une quelconque des revendications 1 à 3, dans lequel les informations de consommation électrique intrinsèque dudit compteur électrique intelligent secondaire (122) sont obtenues par mesures réalisées grâce à une résistance installée en entrée d'alimentation électrique interne (174) dudit compteur électrique intelligent secondaire (122).

6. Procédé selon l'une quelconque des revendications 1 à 3, dans lequel les informations de consommation électrique intrinsèque dudit compteur électrique intelligent secondaire (122) sont obtenues par mesures réalisées par lecture d'un registre, ou d'un espace mémoire, fournissant une estimation prédéterminée de la consommation électrique intrinsèque dudit compteur électrique intelligent secondaire (122).

7. Procédé selon l'une quelconque des revendications 1 à 6, dans lequel ledit compteur électrique intelligent secondaire (122) comporte un organe de coupure pour suspendre et rétablir l'alimentation électrique de l'installation électrique dédiée.

8. Procédé selon l'une quelconque des revendications 1 à 6, dans lequel l'installation électrique dédiée comporte un chargeur (130) pour véhicule électrique qui est muni d'un organe de coupure commandable à distance par ledit compteur électrique intelligent secondaire (122) pour suspendre et rétablir l'alimentation électrique de l'installation électrique dédiée.

9. Système de gestion automatisée (100) comprenant des compteurs électriques intelligents primaires (121) et des compteurs électriques intelligents secondaires (122), chaque compteur électrique intelligent primaire (121) étant configuré pour superviser une installation électrique générale, chaque compteur électrique intelligent secondaire (122) étant connecté en aval d'un dit compteur électrique intelligent primaire (121) et étant configuré pour superviser une installation électrique dédiée qui est une sous-partie de l'installation électrique générale supervisée par le compteur électrique intelligent primaire (121) en question, le système de gestion automatisée (100) comprenant en outre un premier système d'information (111) gérant les compteurs électriques intelligents primaires (121) et un deuxième système d'information (112) gérant les compteurs électriques intelligents secondaires (122),
le système de gestion automatisée (100) comprenant de la circuiterie électronique configurée pour implémenter les étapes suivantes, pour chaque dite installation électrique générale qui comporte un dit compteur électrique intelligent primaire (121) et un dit compteur électrique intelligent secondaire (122) et à laquelle est associé un abonnement de distribution électrique déclaré auprès du premier système d'information (111) et du deuxième système d'information (112) :
- le compteur électrique intelligent primaire (121) collecte des informations de consommation électrique de l'installation électrique générale, et les transmet au premier système d'information (111) ;
- le compteur électrique intelligent secondaire (122) collecte des informations de consommation électrique de l'installation électrique dédiée et des informations de consommation électrique intrinsèque dudit compteur électrique intelligent secondaire (122), et les transmet au premier système d'information (111) et au deuxième système d'information (112) ;
- le premier système d'information (111) soustrait de la consommation électrique de l'installation électrique générale la consommation électrique de l'installation électrique dédiée et la consommation électrique intrinsèque du compteur électrique intelligent secondaire (122), et en impute le résultat à l'abonnement ;
- le premier système d'information (111) impute au deuxième système d'information (112) la consommation électrique intrinsèque dudit compteur électrique intelligent secondaire (122) ; et
- le deuxième système d'information (112) impute à l'abonnement la consommation électrique de l'installation électrique dédiée.
